Europäisches Patentamt

European Patent Office

Office européen des brevets

(19)

(11) Publication number: **0 037 708**
**B1**

# EUROPEAN PATENT SPECIFICATION

(12)

(45) Date of publication of patent specification: 30.07.86

(51) Int. Cl.⁴: **G 03 F 7/26, G 03 F 7/10**

(21) Application number: 81301422.2

(22) Date of filing: 01.04.81

(54) Method of forming patterns.

(30) Priority: 02.04.80 JP 42021/80
27.06.80 JP 86626/80

(43) Date of publication of application:
14.10.81 Bulletin 81/41

(45) Publication of the grant of the patent:
30.07.86 Bulletin 86/31

(84) Designated Contracting States:
DE FR GB NL

(56) References cited:
EP-A-0 021 719
DE-A-2 543 553
DE-A-2 927 242
FR-A-2 316 625

IBM TECHNICAL DISCLOSURE BULLETIN, vol.
20, no. 4, September 1977, New York (US), F.P.
HOOD et al.: "High resolution negative mode
electron-beam resist process", page 1446

J. ELECTROCHEM SOC. SOLID STATE
SCIENCE AND TECHNOLOGY, vol. 126, no. 5,
May 1979, New York (US), HIROYUKI HIRAOKA
et al.: "Electron beam-induced reactions of
orthonaphthoquinone-diazide-sulfonyl
derivatives in phenolic-type resins"

(73) Proprietor: Hitachi, Ltd.
5-1, Marunouchi 1-chome
Chiyoda-ku Tokyo 100 (JP)

(72) Inventor: Mochiji, Kozo
6-77-26, Fujimi-cho Tachikawa-shi
Tokyo (JP)
Inventor: Maruyama, Yoji
1-48-18, Akatsuki-cho Hachioji-shi
Tokyo (JP)
Inventor: Okazaki, Shinji
522, Kamikizaki
Urawa-shi Saitama-ken (JP)
Inventor: Murai, Fumio
2196-531, Hirai Hinodemachi
Nishitama-gun Tokyo (JP)

(74) Representative: Paget, Hugh Charles Edward
et al
MEWBURN ELLIS & CO. 2/3 Cursitor Street
London EC4A 1BQ (GB)

(56) References cited:
IBM TECHNICAL DISCLOSURE BULLETIN, vol.
13, no. 5, October 1970, New York, (US), W.M.
MOREAU et al.: "Variable wave-length
photoresist", page 1303

(56) References cited:

**JOURNAL OF THE ELECTROCHEMICAL SOCIETY, vol. 117, no. 12, December 1970, New York (US), B. BROYDE: "Exposure of photoresists. II Electron and light exposure of a positive photoresist"**

**IBM TECHNICAL DISCLOSURE BULLETIN, vol. 23, no. 4, September 1980, New York, (US), B.M. REAGAN: "Electron-beam-exposed positive photoresist providing image reversal", page 1368**

## Description

The present invention relates to a method of forming patterns, and more specifically to a method of forming fine patterns such as required in semiconductor devices and magnetic bubble memory elements.

The trend toward high densities and a high degree of integration in modern magnetic bubble memory elements and semiconductor integrated circuits has been placing increasing demands for the development of methods which are capable of accurately and easily forming fine patterns having very fine line widths and gaps.

So far, a variety of patterns of magnetic bubble memory elements and semiconductor integrated circuits have, in general, been formed by the method called photolithography.

With conventional photolithography employing electromagnetic radiation of a wavelength of about 320 to 500 nm, however, it is difficult to form fine patterns maintaining high precision due to the effects of diffraction and interference that are characteristics inherent in the light. In order to accurately form fine patterns without being adversely affected by the wavelengths of the light, there has been proposed a so-called electron beam lithographic method which employs electron beams having wavelengths which are much shorter than the wavelengths of ultraviolet light, instead of employing ultraviolet light.

The wavelengths of electron beams are so much shorter than the wavelengths of ultraviolet light that adverse effects caused by interference and diffraction can be neglected, and very fine patterns can be formed while maintaining precision.

In electron beam lithography, a pattern is described by the electron beam on a resist film applied onto a workpiece (such as a metal film, silicon oxide film or the like), and is subjected to developing to form a desired resist pattern.

By using the resist pattern as a mask, the underlying workpiece is processed by etching to form a pattern in the workpiece. With so-called wet etching employing an etching solution, however, it is difficult to accurately form fine patterns smaller than about 1 µm. Therefore, a dry etching method is employed, utilizing sputtering properties of low-temperature plasma or highspeed ions. Therefore, the resist film exposed to the electron beam must have high resolving power, and must not be deteriorated or deformed by the dry etching.

At present, however, there is no resist film for exposure to electron beams, that has high resolving power and excellent resistance against the dry etching; this fact hinders the development of the electron beam lithographic method.

For example, PMMA (polymethyl methacrylate) which is a positive-type resist for exposure to electron beams, has good resolving power and is capable of forming a resist pattern having a width of about 0.8 µm. However, if a PSG film (phosphorus glass film) is subjected to etching by reactive sputtering using $C_4F_8$ and helium gases with the PMMA as a mask, abnormal wrinkles develop on the whole surfaces of the resist film. Namely, the pattern is deformed by the wrinkles, and it becomes difficult to obtain a good resist pattern.

PGMA (polyglycidyl methacrylate) which is a negative resist for exposure to electron beams gives a resolving power of up to about 1.2 µm. When an aluminum film is subjected to etching by reactive sputtering using $BCl_3$ gas with the PGMA as a mask, however, the thickness of the PGMA must be increased since it has a large etching ratio. Consequently, it is impossible to realize the resolving power of the order of 1 µm. An example of such a method is disclosed in DE—A—2543553 in which a photoresist is first de-polymerised by ultraviolet radiation, then selected parts are re-polymerised by an electron beam. The remaining de-polymerised parts we removed to form a mask.

Moreover, although various resists for exposure to electron beams have been developed, there is still available no resist film which has high resolving power and resistance against dry etching.

Therefore, it is difficult to form good fine patterns by electron beam lithography.

With electron beam lithography, furthermore, the portions to be exposed must be successively scanned by the electron beam which is finely converged. Therefore, the scanning requires extended periods of time, and the productivity is low.

In an article by F. P. Hood *et al* is IBM Technical Disclosure Bulletin, Vol. 20, No. 4, of September 1977 there is disclosed a method in which a positive-acting resist film is formed and predetermined regions of the film are irradiated with an electron beam. Then the entire film is exposed to ultra-violet light. Subsequently the photoresist film is developed and only the regions exposed to the electron beams are removed. This document corresponds to the pre-characterising portion of Claim 1. However the exposure to ultra-violet light is carried out in two stages, a first of which completes the conversion of the predetermined regions of the photoresist film, and a second which acts on the parts of the film not exposed to the electron beam. Between these two steps, the photoresist film is heat treated.

Heat treatment also occurs in the methods of FR—A—2316625 and EP—A—0021719 (the latter published after the priority date of the present invention). In the method described in these documents, the photoresist film is exposed to an electron beam and then heat treated prior to exposure to ultra-violet light. The heat treatment causes a reaction in the predetermined regions exposed to the electron beam which makes the predetermined regions insoluble.

Therefore the present invention proposes a method of forming a pattern comprising:

adhering a positive-type photoresist film onto a layer to be processed;

irradiating predetermined regions of the photoresist film with radiation of a first, smaller wavelength;

irradiating regions of the photoresist film including at least the predetermined regions with radiation of a second, larger wavelength;

developing the positive-type photoresist film and removing those regions which have been irradiated only at the larger wavelength, to form a resist pattern;

characterised in that:

the irradiation by the radiation of the first wavelength is of a sufficient intensity to destroy the photosensitive radicals of the positive-type photoresist film in the predetermined regions, whereby the predetermined regions are rendered insensitive to the radiation of the second wavelength; and

after the formation of the resist pattern, portions of the layer to be processed not covered by photoresist film are removed by etching using the resist pattern as a mask and then the resist pattern is removed.

Examples of the invention will now be described with reference to the accompanying drawings, in which:

Figs. 1a to 1d illustrate the steps according to an embodiment of the present invention;

Fig. 2 is a graph which shows the relationship between the intensity of the electron beam and the film thickness after developing, when the photoresist AZ1350J is treated according to the present invention; and

Figs. 3a to 3f illustrate the steps according to another embodiment of the present invention.

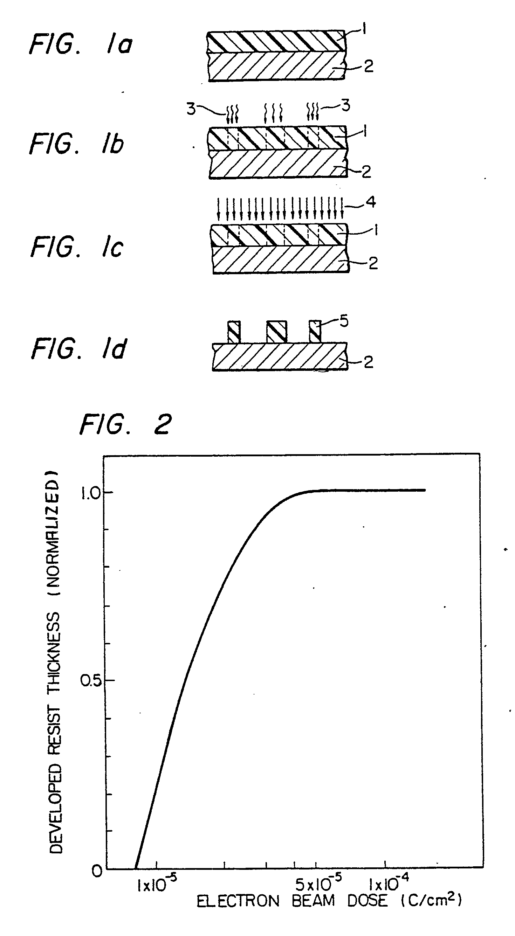

Referring to Fig. 1a, a positive-type photoresist AZ1350J (trade name, a produce of Shippley Co., U.S.A.) is applied as a resist film 1 to a thickness of 0.6 to 1.0 µm on the surface of a film (metal film, insulating film or the like on a semiconductor substrate) 2 on which a pattern is to be formed.

The resist film 1 is heat-treated at 90°C for 30 minutes (this heat treatment is referred to as prebake in this specification).

## Example 1

Referring to Fig. 1b, the resist film 1 is irradiated with an electron beam 3 to describe a desired pattern. In this case, the optimum dosage of electrons will be from $1 \times 10^{-5}$ to $5 \times 10^{-5}$ C/cm$^2$.

The resist film 1 irradiated with the electron beam is then exposed over its whole surface to ultraviolet light 4 as shown in Fig. 1c. In this case, an ultra-high pressure mercury lamp is used as the source of light, and the exposure is effected at an intensity of 7 to 8 mJ/cm$^2$ over 10 to 30 seconds. In the photoresist film, the regions irradiated only with ultraviolet light 4 exhibit markedly increased solubility.

The regions irradiated with the electron beam 3 in the previous step may thereby exhibit slightly increased solubility. In this case, however, since photosensitive radicals possessed by the photoresist film 1 are destroyed by the electron beam, such regions do not develop photochemical reaction when they are irradiated with ultraviolet light 4 in the above step. Therefore, the solubility of such regions is not increased in this step.

The increase in solubility of the positive-type photoresist caused by the irradiation with ultraviolet light is far greater than the increase in solubility caused by the irradiation with the electron beam. Accordingly, there are formed regions having a greatly increased solubility caused by the irradiation with the ultraviolet light 4, and regions having slightly increased solubility caused by the irradiation with the electron beam.

The photoresist film 1 is then subjected to a heat-treatment at 100° to 130°C for 30 minutes (this heat treatment is referred to as an after-bake in this specification), and is then developed. Namely, the regions irradiated with the ultraviolet light 4 only are dissolved and removed. The regions irradiated with both the electron beam 3 and ultraviolet light 4, however, are not removed but remain. A resist pattern 5 is thus formed as shown in Fig. 1d.

The developing is effected by immersing the film in a solution of organic ammonium or in an alkali aqueous solution at a solution temperature of 20° to 25°C for 1 to 2 minutes.

In accordance with the present invention as mentioned above, a step of exposing the whole surface of the film to ultraviolet light is added to the ordinary step of treating the resist film with an electron beam. This method makes it possible to accurately form fine resist patterns of a size of smaller than 1 µm.

Fig. 2 is a graph of the sensitivity curve of a resist with respect to the electron beam, the resist being obtained by treating the photosensitive resist AZ1350J under the above-mentioned conditions. The abscissa represents the dosage of electron beam (C/cm$^2$) and the ordinate represents the ratio of film thickness of the negative-type pattern after developing (thickness of the resist film of the portions irradiated with the electron beam after developing to thickness of the resist film after the pre-bake). As will be obvious from Fig. 2, the resist pattern is formed if the dosage of electron beam is greater than about $1 \times 10^{-5}$ C/cm$^2$. To obtain sharp patterns, however, the dosage of electrons should be $1 \times 10^{-5}$ to $5 \times 10^{-5}$ C/cm$^2$.

## Example 2

Good resist patterns having line widths and gaps of 1.0 µm, 1.5 µm, 2.0 µm and 3.0 µm are obtained when the AZ1350J photoresist having a thickness of 0.55 µm is treated in accordance with the steps of Example 1 under the conditions of an electron beam dosage of $3 \times 10^{-5}$ C/cm$^2$, an ultraviolet light exposure of 8 mJ/cm$^2$, and effecting the after-bake at 110°C for 20 minutes, and then developing using MF312 (a developing solution prepared exclusively for AZ photoresist, a product of Shippley Co.): water = 50:100.

When a pattern is formed by using the negative-type electron beam resist according to the conventional method, hair-like scums develop when the gaps in linear patterns become smaller than 1 μm, and it becomes necessary to remove scums by treatment with oxygen plasma or the like. With the present method, however, there develops no scum, and very sharp patterns can be formed.

### Example 3

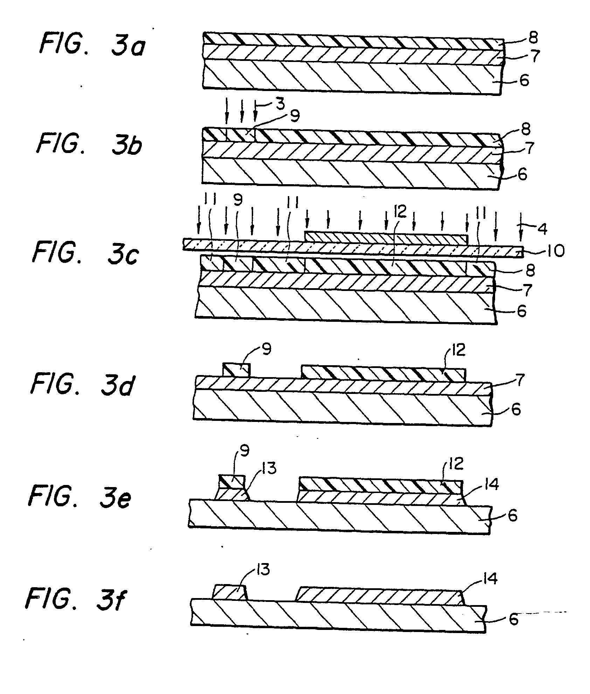

Fig. 3 is a diagram illustrating the steps according to another embodiment of the present invention.

Referring to Fig. 3a, first, an aluminum film 7 which is to be processed is formed by a vacuum vaporization method on the surface of a silicon substrate 6, and AZ135OJ (trade name, a product of Shippley Co.) is applied as a photoresist film 8 to a thickness of 0.8 μm onto the aluminum film 7.

After pre-baking at 80°C for 20 minutes, a desired region 9 in the photoresist film 8 is irradiated with an electron beam 3 as shown in Fig. 3b using an electron-beam lithographic apparatus. The electron beam dosage in this case is $3 \times 10^{-5}$ coulomb/cm².

Referring to Fig. 3c, desired regions 11 in the photoresist film 8 and the region 9 irradiated with the electron beam 3 in the above step, are selectively irradiated with ultraviolet light 4 using a chromium mask 10. The irradiation is effected by using a mercury lamp having an output of 13 mW/cm² as a source of light, for an exposure time of 12 seconds.

The regions 11 in the photoresist film 8 irradiated with the ultraviolet light 4 exhibit increased solubility, but the regions 12 which are not irradiated with the ultraviolet light do not exhibit an increased solubility.

The region 9 irradiated with the electron beam 3 in the previous step exhibits slightly increased solubility as a result. However, since the photosensitive radicals have been destroyed by the irradiation with electrons, the solubility of the region 9 is not further increased when it is irradiated with the ultraviolet light 4.

The positive-type photoresist irradiated with only the ultraviolet light exhibits far greater solubility than the solubility of the portions irradiated with the electron beam. Consequently, there are formed regions 11 having the greatest solubility owing to the irradiation with the ultraviolet light 4 only, the region 9 having slightly increased solubility being irradiated with both the electron beams 3 and ultraviolet light 4, and the region 12 which is irradiated with neither the electron beam nor the ultraviolet light and which exhibits the original solubility.

When after-baking is effected at 120°C for 20 minutes, followed by developing using the MF—312 developer or the AZ developer (which are developing solutions for the AZ135OJ produced by Shippley Co.) at a liquid temperature of 23°C for 1 minute, the regions 11 irradiated with the ultraviolet light only are removed, and the region 12 which is not irradiated with the rays and the region 9 irradiated with both the electron beam and ultraviolet light are left, thereby to form resist patterns 9, 12 as shown in Fig. 3d, since the solubility of the regions 11 irradiated with the ultraviolet light only is much greater than the solubility of the region 9 irradiated with both the electron beam and ultraviolet light.

After the after-baking is effected at 120°C for 20 minutes, if the exposed portions of the aluminum film 7 are removed as shown in Fig. 3e using resist patterns 9, 12 formed by the above-mentioned developing as masks, and if the resist pattern is removed from the aluminum film, there are formed patterns 13, 14 consisting of aluminum film as shown in Fig. 3f.

As will be obvious from the foregoing description, the shape of the pattern 13 is determined by the irradiation with electron beams, and the shape of the pattern 14 is determined by the irradiation with ultraviolet light.

The irradiation with electrons makes it possible to form fine patterns maintaining very high precision. Therefore, the above pattern 13 is suited for forming wirings in the semiconductor devices.

On the other hand, the pattern formed by the irradiation of ultraviolet light is of lower precision than the pattern formed by the irradiation with the electron beam. Therefore, the pattern 14 is suited for forming scribe lines or bonding pads of semiconductor devices having relatively wide areas and which do not require strict precision for the shapes and sizes.

Magnetic bubble memory elements and semiconductor integrated circuits contain fine patterns which require very high precision and patterns of relatively large areas which do not require high precision.

Electron beam lithography helps obtain very high precision. When used for forming patterns of large areas, however, electron beam lithography requires greatly extended periods of time before the patterns are described. When ultraviolet light is employed, on the other hand, the exposure needs be effected one time only, but it is difficult to form fine patterns maintaining precision.

In other words, if it is attempted to form all patterns in the magnetic bubble memory elements and semiconductor integrated circuits by electron beam lithography, the patterns can be formed with high precision but requiring greatly extended periods of time. If ultraviolet light only is employed, on the other hand, it is difficult to obtain fine patterns maintaining high precision.

According to the present method, however, only fine patterns which require high precision are formed by irradiation with electrons, and patterns of large areas which do not require high precision are formed by irradiation with ultraviolet light. Therefore, patterns of required precision can be formed without requiring extended periods of time. Furthermore, as will be apparent from the foregoing description, the present method can be very easily put into practice without requiring skilled work or any particularly designed devices.

The present invention was accomplished based on a discovery that the solubility of the positive-type photoresist increases quite differently depending upon whether it is irradiated with an electron beam or ultraviolet light, and that the regions irradiated with the electron beams do not exhibit increased solubility even when it is further irradiated with ultraviolet light. This fact makes the present invention greatly distinguished over the prior art.

It is important that the photosensitive radicals in the positive-type photoresist are substantially destroyed by the irradiation with the electron beam, and the solubility is not increased by the irradiation with the ultraviolet light.

In order to reliably destroy the photosensitive radicals the intensity of the electron beam to be irradiated must be greater than about $1 \times 10^{-6}$ coulomb/cm$^2$. When the intensity of the electron beam is smaller than the above value, the photosensitive radicals are not sufficiently destroyed, and the solubility is increased by the irradiation with ultraviolet light and, hence, the positive-type photoresist is dissolved by the developing and is removed.

When the intensity of the electron beam becomes greater than about $1 \times 10^{-4}$ coulomb/cm$^2$, on the other hand, it becomes difficult to form fine patterns. Therefore, the intensity of the electron beam should range from about $1 \times 10^{-6}$ to $1 \times 10^{-4}$ coulomb/cm$^2$.

The ultraviolet light should be irradiated under the conditions in which the positive-type photoresist is ordinarily exposed. For example, good results will be obtained when the mercury lamp having an output of 13 mW is used as a source of light, and the irradiation is continued for 8 seconds.

Although the above-mentioned embodiment has employed the photoresist AZ135OJ, it is of course possible to use the AZ-type photoresists such as AZ2400 and the like that have been placed in the market by Shippley Co.

The present invention can further be put into practice by using not the AZ-type photoresists but instead using other positive-type photoresists such as OFPR-type photoresists manufactured by Tokyo Ohka Kogyo Co. The positive-type photoresists can be developed by using the manufacturer's specified developing liquids under the specified conditions. For the AZ-type photoresists, there can be used MF-312 developer, AZ developer or AZ2401 developer depending upon the kind of the photoresist or the irradiation conditions. The developing will be effected under specified conditions of, for example, 23°C for 1 minute.

The pre-baking effected prior to the irradiation with the electron beam is a widely accepted practice in the art of photolithography, and is advantageous from the standpoint of increasing the adhesiveness by removing solvent. The pre-baking should be effected at a temperature of about 60° to 90°C for 20 to 30 minutes.

The after-baking which is effected after the ultraviolet light have been irradiated but before the developing is effected, is not an essential requirement for the present invention but is very effective from the practical point of view. The baking should be effected at a temperature of 100° to 140°C.

When the after-baking is effected at a temperature of lower than 100°C, little adhesiveness is exhibited with respect to the layer that is to be processed. When the after-baking is effected at a temperature of higher than 140°C, the thermal crosslinking reaction of the polymer proceeds, and the solubility of the whole photoresist film so decreases that it becomes difficult to effect the developing. The most desirable temperature ranges from 120° to 130°C.

The baking (post-baking) effected after the developing is not an indispensable step for the present invention. The baking, however, is effected to increase the resistance of the layer when it is to be subjected to etching using the resist pattern as a mask. The baking is effected at a temperature of nearly 90° to 100°C.

The layer to be processed may be subjected to the ordinary wet-type etching using various etching solutions. The precision, however, can be greatly increased by dry-type etching such as etching by the reactive sputtering.

According to the conventional method, the positive-type photoresist is simply used to form a photoresist pattern. Therefore, the photoresist has very small resistance against dry etching, and it is difficult to subject a metal film or an insulation film to the dry etching by using the positive-type photoresist as a mask. According to the present invention, however, the photosensitive radicals are destroyed by the irradiation with the electron beam and the photoresist pattern is hardened to exhibit very great resistance against dry etching. Therefore, it is allowed to effect the dry etching using the thus hardened photoresist pattern as a mask. According to the present invention, therefore, it is easy to form fine patterns having a line width of 0.5 µm. If the beam of electrons is converged more finely, it is possible to form patterns having line widths of 0.2 to 0.3 µm.

Instead of irradiating with an electron beam, it is also possible to use the so-called far ultraviolet light having wavelengths smaller than about 300 nm in combination with the above-mentioned ultraviolet light, such that the regions irradiated with the far ultraviolet light are left as photoresist patterns like the case when an electron beam is used.

In this case, a suitable dosage of far ultraviolet light for forming the photoresist patterns will be from about 200 to 300 mW/cm$^2$ sec.

As illustrated in the foregoing, photoresist patterns are formed having increased resistance against dry etching. Namely, the photoresist patterns are very suited for processing workpieces by dry etching. Furthermore, the present invention is capable of quickly forming fine patterns which require a high degree of precision together with patterns which require relatively small precision, and is very effective for the production of magnetic bubble memory elements and semiconductor integrated circuits in which such patterns are contained in a mixed manner.

**Claims**

1. A method of forming a pattern comprising:
adhering a positive-type photoresist film (1, 8) onto a layer (2, 7) to be processed;
irradiating predetermined regions (5, 9) of the photoresist film (1, 8) with radiation of a first, smaller wavelength;
irradiating regions (11) of the photoresist film (1, 8) including at least the predetermined regions with radiation of a second, larger wavelength;
developing the positive-type photoresist film (1, 8) and removing those regions which have been irradiated only at the larger wavelength, to form a resist pattern;
characterised in that:
the irradiation by the radiation of the first wavelength is of a sufficient intensity to destroy the photosensitive radicals of the positive-type photoresist film (1, 8) in the predetermined regions (9), whereby the predetermined regions (9) are rendered insensitive to the radiation of the second wavelength; and
after the formation of the resist pattern, portions of the layer to be processed not covered by photoresist film are removed by etching using the resist pattern as a mask, and then the resist pattern is removed.

2. A method according to claim 1 wherein the radiation (4) of the second, larger wavelength is ultraviolet light.

3. A method according to claim 1 or claim 2 wherein the whole surface of the photoresist film (1) is irradiated with the radiation (4) of the second wavelength.

4. A method according to claim 1 or claim 2 wherein only predetermined regions (11) of the photoresist film (8) are irradiated with the radiation (4) of the second wavelength.

5. A method according to any one of the preceding claims wherein the radiation (3) of the first, smaller wavelength is a beam of electrons.

6. A method according to claim 5 wherein the intensity of the electron beam (3) is about $1 \times 10^{-6}$ to $1 \times 10^{-4}$ coulomb/cm$^2$.

7. A method according to any one of the preceding claims wherein the photoresist film (1, 8) is heated at about 100°C to 140°C after it is exposed to the radiation (4) of the second wavelength but before it is developed.

8. A method according to any one of the preceding claims, wherein the entire surface of the photoresist film (1, 8) is irradiated with the radiation of the second wavelength through a mask (10).

9. A method according to any one of the preceding claims, wherein the portions of the layer to be processed not covered by photoresist film are removed by dry etching.

10. A method according to any one of the preceding claims, wherein the photoresist film (1, 8) is heated to a temperature between about 60°C and 90°C prior to irradiation with the radiation of the first wavelength.

11. A method according to any one of the preceding claims wherein the resist pattern is baked at a temperature between 90°C and 100°C between the development of the photoresist film (1, 8) and the removal of the exposed portions of the layer to be processed.

**Patentansprüche**

1. Verfahren zur Ausbildung eines Musters, aufweisend:
zur-Haftung-Bringen eines Positiv-Fotoresistfilms (1, 8) auf einer zu bearbeitenden Schicht (2, 7);
Bestrahlen vorgegebener Bereiche (5, 9) des Fotoresistfilms (1, 8) mit Strahlung einer ersten, kleineren Wellenlänge;
Bestrahlen von Bereichen (11) des Fotoresistfilms (1, 8), die zumindest die vorgegebenen Bereiche umfassen, mit Strahlung einer zweiten, größeren Wellenlänge;
Entwickeln des Positiv-Fotoresistfilms (1, 8) und Entfernen der Bereiche, die nur bei der größeren Wellenlänge bestrahlt wurden, um ein Resistmuster zu bilden;
dadurch gekennzeichnet,
daß die Bestrahlung mit der Strahlung der ersten Wellenlänge eine hinreichende Intensität aufweist, um die fotoempfindlichen Radikale des Positiv-Fotoresistfilms (1, 8) in den vorgegebenen Bereichen (9) zu zerstören, wodurch die vorgegebenen Bereiche (9) für die Strahlung der zweiten Wellenlänge unempfindlich gemacht werden; und
daß nach Bildung des Resistmusters Bereiche der zu bearbeitenden Schicht, die nicht vom Fotoresistfilm bedeckt sind, durch Ätzen unter Verwendung des Resistmusters als einer Maske entfernt werden, und anschließend das Resistmuster entfernt wird.

2. Verfahren nach Anspruch 1, wobei die Strahlung (4) der zweiten, größeren Wellenlänge Ultraviolett-Licht ist.

3. Verfahren nach Anspruch 1 oder Anspruch 2, wobei die gesamte Oberfläche des Fotoresistfilms (1) mit der Strahlung (4) der zweiten Wellenlänge bestrahlt wird.

4. Verfahren nach Anspruch 1 oder Anspruch 2, wobei nur bestimmte Bereiche (11) des Fotoresistfilms (8) mit der Strahlung (4) der zweiten Wellenlänge bestrahlt werden.

5. Verfahren nach einem der vorhergehenden Ansprüche, wobei die Strahlung (3) der ersten, kleineren Wellenlänge ein Elektronenstrahl ist.

6. Verfahren nach Anspruch 5, wobei die Intensität des Elektronenstrahls (3) etwa $1 \times 10^{-6}$ bis $1 \times 10^{-4}$ Coulomb/cm$^2$ beträgt.

7. Verfahren nach einem der vorhergehenden Ansprüche, wobei der Fotoresistfilm (1, 8) auf etwa 100°C bis 140°C erhitzt wird, nachdem er der Strahlung (4) der zweiten Wellenlänge ausgesetzt wurde, jedoch bevor er entwickelt wird.

8. Verfahren nach einem der vorhergehenden Ansprüche, wobei die gesamte Oberfläche des Fotoresistfilms (1, 8) mit der Strahlung der zweiten Wellenlänge durch eine Maske (10) bestrahlt wird.

9. Verfahren nach einem der vorhergehenden Ansprüche, wobei die Bereiche der zu bearbeitenden Schicht, die nicht vom Fotoresistfilm bedeckt sind, durch Trockenätzen entfernt werden.

10. Verfahren nach einem der vorhergehenden Ansprüche, wobei der Fotoresistfilm (1, 8) vor der Bestrahlung mit der Strahlung der ersten Wellenlänge auf eine Temperatur zwischen etwa 60°C und 90°C erhitzt wird.

11. Verfahren nach einem der vorhergehenden Ansprüche, wobei das Resistmuster zwischen der Entwicklung des Fotoresistfilms (1, 8) und der Entfernung der freigelegten Bereiche der zu bearbeitenden Schicht auf einer Temperatur zwischen 90°C und 100°C gebrannt wird.

**Revendications**

1. Procédé pour former un modèle, du type consistant à:

— fixer par adhérence une pellicule de résine photosensible à effet positif (1, 8) sur une couche (2, 7) devant être traitée,

— irradier des régions prédéterminées (5, 9) de la pellicule de résine photosensible (1, 8) avec un rayonnement possédant une première longueur d'onde plus faible;

— irradier les régions (11) de la pellicule de résine photosensible (1, 8) incluant au moins les régions prédéterminées, avec un rayonnement possédant une seconde longueur d'onde plus grande;

— développer la pellicule de résine photosensible à effet positif (1, 8) et éliminer les régions qui ont été irradiées uniquement avec la longueur d'onde plus élevée, de manière à former un modèle de résine photosensible;

caractérisé en ce que:

— l'irradiation effectuée par le rayonnement possédant la première longueur d'onde possède une intensité suffisante pour détruire les radicaux photosensibles de la pellicule de résine photosensible à effet positif (1, 8) dans les régions prédéterminées (9) ce qui rend ces régions insensibles au rayonnement possédant la seconde longueur d'onde; et

— après la formation du modèle de résine photosensible, on élimine par attaque chimique des parties, non recouvertes par la pellicule de résine photosensible, de la couche devant être traitée, en utilisant le modèle de résine photosensible en tant que masque, puis on élimine la pellicule de résine photosensible.

2. Procédé selon la revendication 1, selon lequel le rayonnement (4) possédant la seconde longueur d'onde plus élevée est une lumière ultraviolette.

3. Procédé selon la revendicaton 1 ou 2, selon lequel on irradie l'ensemble de la surface de la pellicule de résine photosensible (1) avec le rayonnement (4) possédant la seconde longueur d'onde.

4. Procédé selon la revendication 1 ou 2, selon lequel seules des régions prédéterminées (11) de la pellicule de résine photosensible (8) sont irradiées à l'aide du rayonnement (4) possédant la seconde longueur d'onde.

5. Procédé selon l'une quelconque des revendications précédentes, selon lequel le rayonnement (3) possédant la première longueur d'onde plus faible est un faisceau d'électrons.

6. Procédé selon la revendication 5, selon lequel l'intensité du faisceau d'électrons (3) est comprise entre environ $1 \times 10^{-6}$ et $1 \times 10^{-4}$ coulombs/cm².

7. Procédé selon l'une quelconque des revendications précédentes, selon lequel on chauffe la pellicule de résine photosensible (1, 8) à une température comprise entre 100°C et 140°C, à la suite de quoi on l'expose au rayonnement (4) possédant la seconde longueur d'onde, avant de la développer.

8. Procédé selon l'une quelconque des revendications précédentes, selon lequel on irradie l'ensemble de la surface de la pellicule de résine photosensible (1, 8) avec le rayonnement possédant la seconde longueur d'onde, moyennant l'interposition d'un masque (10).

9. Procédé selon l'une quelconque des revendications précédentes, selon lequel on élimine par attaque chimique à sec les parties, recouvertes par la pellicule de résine photosensible, de la couche devant être traitée.

10. Procédé selon l'une quelconque des revendications précédentes, selon lequel on chauffe la pellicule de résine photosensible (1, 8) à une température comprise entre environ 60°C et 90°C avant son irradiation au moyen du rayonnement possédant la première longueur d'onde.

11. Procédé selon l'une quelconque des revendications précédentes, selon lequel on fait cuire le modèle de résine à une température comprise entre 90°C et 100°C, entre le développement de la pellicule de résine photosensible (1, 8) et l'enlèvement des parties exposées de la couche devant être traitée.

0 037 708

FIG. 1a

FIG. 1b

FIG. 1c

FIG. 1d

FIG. 2

DEVELOPED RESIST THICKNESS (NORMALIZED)

ELECTRON BEAM DOSE (C/cm$^2$)

1

FIG. 3a

FIG. 3b

FIG. 3c

FIG. 3d

FIG. 3e

FIG. 3f